# EUROPÄISCHE PATENTSCHRIFT

(11) **EP 3 996 130 B1**
(45) Veröffentlichungstag und Bekanntmachung des Hinweises auf die Patenterteilung: **08.03.2023**
(21) Anmeldenummer: 20206455.6
(22) Anmeldetag: 09.11.2020
(51) Int. Cl.: H01L 21/67, C30B 25/16, C30B 29/06, C30B 23/00

(54) **VERFAHREN ZUM ABSCHEIDEN EINER EPITAKTISCHEN SCHICHT AUF EINER SUBSTRATSCHEIBE**
METHOD FOR DEPOSITING AN EPITAXIAL LAYER ON A SUBSTRATE WAFER
PROCÉDÉ DE DÉPÔT D'UNE COUCHE ÉPITAXIÉE SUR UNE TRANCHE DE SUBSTRAT

(43) Veröffentlichungstag der Anmeldung: 11.05.2022
(73) Patentinhaber: Siltronic AG, 81677 München (DE)
(72) Erfinder: Stettner, Thomas, 83329 Waging am See (DE)
(74) Vertreter: Staudacher, Wolfgang

(56) Entgegenhaltungen:
- WO-A1-2014/103657
- DE-A1-102017 210 423
- DE-B4-112011 103 769
- JP-A- 2010 034 372
- JP-A- 2012 227 471
- JP-A- 2015 201 599
- US-A1- 2016 172 254
- US-A1- 2017 117 228
- US-A1- 2018 226 304

## Beschreibung

Gegenstand der Erfindung ist ein Verfahren zum Abscheiden einer epitaktischen Schicht auf einer Substratscheibe.

### Stand der Technik / Probleme

Für anspruchsvolle Anwendungen in der elektronischen Industrie werden epitaktisch beschichtete Halbleiterscheiben, insbesondere Substratscheiben aus einkristallinem Silizium benötigt, die mit einer Schicht aus Silizium epitaktisch beschichtet sind.

Ein häufig verwendetes Verfahren zum Abscheiden der Schicht stellt die Gasphasenabscheidung dar. Das Material für die Schicht wird dabei von Prozessgas bereitgestellt, das über die zu beschichtende Seite der Substratscheibe bei Temperaturen geleitet wird, bei denen sich eine im Prozessgas enthaltene Vorläuferverbindung, die das Material enthält, chemisch spaltet. Das Verfahren wird in der Regel in einer Vorrichtung durchgeführt, die als Einzelscheibenreaktor ausgeführt ist. Ein solcher Einzelscheiben-Reaktor ist beispielsweise in EP 0 870 852 A1 beschrieben.

Die Substratscheibe liegt während des Abscheidens der Schicht auf der Ablagefläche einer Tasche (pocket) eines Suszeptors, währenddessen sie von einer Begrenzung der Ablagefläche umgeben ist. Eine hervorgehobene Randposition einer Halbleiterscheibe ist die Notchposition, wo eine Orientierungskerbe (Notch) die Orientierung des Kristallgitters kennzeichnet. In US 2017 0 117 228 A1 ist ein Suszeptor beschrieben, bei dem die Ablagefläche oder die Ablagefläche und die äußere Begrenzung der Ablagefläche an der Notchposition nach innen ragen.

Damit die epitaktische Schicht möglichst gleichmäßig auf der Substratscheibe wächst, besteht ein besonderes Interesse daran, dass die Substratscheibe zentrisch zur äußeren Begrenzung in der Ablagefläche liegt.

In US 2010 0 216 261 A1 wird vorgeschlagen, die korrekte Lage der Substratscheibe auf dem Suszeptor mittels eines Kamerasystems zu überwachen.

In WO17 135 604 A1 wird beschrieben, nach dem Abscheiden der epitaktischen Schicht einen Dickenkennwert im Randbereich zu messen und in Abhängigkeit des Messergebnisses bestimmte Prozess-Parameter für nachfolgende Abscheidevorgänge zu ändern.

WO 14 103 657 A1 und JP2015 201 599 A offenbaren Verfahren, die ausgehend von der Verteilung von Dickenkennwerten im Randbereich der Halbleiterscheibe mit epitaktisch abgeschiedener Schicht eine Exzentrizität berechnen, um in Abhängigkeit von dieser Exzentrizität die Lage einer nachfolgenden Substratscheibe auf dem Suszeptor zu korrigieren.

US 2009 0 252 942 A1 und JP2002 043 230 A schlagen vor, die Ebenheit der Substratscheibe vor dem Abscheiden der epitaktischen Schicht zu messen und während des Abscheidens bestimmte Prozess-Parameter so zu ändern, dass mit dem Beschichten der Substratscheibe ein Randabfall geringer wird.

Allerdings lassen sich Dickenunterschiede im Randbereich der epitaktisch beschichteten Substratscheibe mit dieser Vorgehensweise nicht vermeiden, wenn die Substratscheibe selbst schon Dickenunterschiede im Randbereich aufweist.

Aufgabe der Erfindung ist es, eine Lösung des Problems anzubieten, die ermöglicht, die Dicke der epitaktischen Schicht im Randbereich an unterschiedlichen Positionen des Umfangs der Substratscheibe unterschiedlich einzustellen.

Die Aufgabe der Erfindung wird gelöst durch ein Verfahren zum Abscheiden einer epitaktischen Schicht auf einer Substratscheibe aus einer Gasphase, umfassend das Messen einer Randgeometrie der Substratscheibe, das einem Rand der Substratscheibe in Abhängigkeit von Randpositionen einen Dickenkennwert zuweist, auch den Dickenkennwert an einer Notchposition;
das Ablegen der Substratscheibe auf einer Ablagefläche einer Tasche eines Suszeptors einer Vorrichtung zum Abscheiden der epitaktischen Schicht, wobei die Ablagefläche von einer äußeren Begrenzung umgeben ist;
das Erhitzen der Substratscheibe; und
das Leiten von Prozessgas über die Substratscheibe;
gekennzeichnet durch
das Überprüfen ob der Dickenkennwert an der Notchposition um mehr als eine prozentuale Schranke vom Dickenkennwert an einer Randposition mit dem größten Dickenkennwert abweicht;
das Ablegen der Substratscheibe auf der Ablagefläche derart, dass der Abstand, den die Substratscheibe zur äußeren Begrenzung der Ablagefläche hat, an der Randposition mit dem größten Dickenkennwert kleiner ist, als an den anderen Randpositionen, sofern die Abweichung größer als die prozentuale Schranke ist, oder derart, dass der Abstand, den die Substratscheibe zur äußeren Begrenzung der Ablagefläche hat, an der Notchposition kleiner ist, als an den anderen Randpositionen, sofern die Abweichung nicht größer als die prozentuale Schranke ist.

Der Erfindung liegt die Erkenntnis zugrunde, dass das zentrierte Ablegen der Substratscheibe in der Tasche mit der Erwartung einhergeht, dass die Substratscheibe eine einheitliche Randgeometrie besitzt. In der Praxis ist das jedoch eher selten der Fall, weil Bearbeitungsschritte wie Schleifen und Polieren nicht in der Lage sind, eine Substratscheibe mit vollständig einheitlicher Randdicke zu schaffen. Das erfindungsgemäße Verfahren ist in der Lage, die Randgeometrie einer epitaktisch beschichteten Halbleiterscheibe im Vergleich zur unbeschichteten Substratscheibe zu vereinheitlichen, insbesondere, wenn die Substratscheibe in einem Randabschnitt eine vergleichsweise niedrige Randdicke besitzt und im gegenüberliegenden Randabschnitt eine vergleichsweise hohe Randdicke. Ungeachtet dessen kann auch eine Homogenisierung der Randdicke erreicht werden, wenn beispielsweise nur ein Randabschnitt mit vergleichsweise niedriger Randdicke vorhanden ist.

Allerdings fällt der Notchposition eine besondere Bedeutung zu. Dort kann im Verlauf des Abscheidens der epitaktischen Schicht in Folge zusätzlicher Materialabscheidung auf der Rückseite der Substratscheibe eine zulässige Randdicke leicht überschritten werden.

Zunächst wird die Randgeometrie der Substratscheibe gemessen, so dass sie in Form eines Dickenkennwerts zur Verfügung steht. Vorzugsweise wird ein äußerstes Randstück mit einer radialen Länge von 1 mm oder 2 mm als Randausschluss (edge exclusion) von der Messung ausgenommen. Als Dickenkennwert kommt prinzipiell jeder Messwert in Frage, der eine Aussage über die relative Dicke an zwei unterschiedlichen Abschnitten im Randbereich der Substratscheibe zu machen erlaubt. Beispielsweise eignet sich als Dickenkennwert der ZDD (Z double derivative) der Vorderseite, der die Krümmung des Randabfalls beschreibt und in der SEMI-Norm M68-0720 definiert ist, oder der ESFQR, der die Ebenheit von Sektoren (sites) im Randbereich quantifiziert und in der SEMI-Norm M67-0720 definiert ist. Die weitere Beschreibung verwendet stellvertretend ESFQR als Dickenkennwert.

Das erfindungsgemäße Verfahren sieht vor, die Randgeometrie einer Substratscheibe vor deren Beschichtung mit einer epitaktischen Schicht zu messen. Danach liegt beispielsweise eine Karte vor, die jedem Sektor einen ESFQR-Wert zuordnet und damit ein Dickenprofil der Substratscheibe entlang von deren Umfang anzeigt. Substratscheiben mit einer keilartigen Form des Querschnitts oder solche, die an einem Randabschnitt dünner sind als an anderen sind besonders geeignet. Mit Randabschnitt ist ein Randbereich gemeint, der sich über eine Strecke von bis zu 50 % des Umfangs, vorzugsweise 7 % bis 42 % des Umfangs in Umfangsrichtung erstreckt. Eine Substratscheibe mit keilartiger Form hat einen dickeren Randabschnitt und einen dünneren Randabschnitt, die sich gegenüberliegen, also den größtmöglichen Abstand zueinander haben.

Für die zur Beschichtung der Substratscheibe zum Einsatz kommende Abscheidekammer, einen Einzelscheiben-Reaktor, wird eine Korrelations-Funktion erstellt, die einem Verschiebevektor einen Dickenkennwert-Unterschied zuordnet. Der Verschiebevektor zeigt die Richtung und den Betrag an, um den die Substratscheibe mit dem dickeren Randabschnitt aus der zentrierten Lage versetzt in die Tasche des Suszeptors gelegt werden muss, damit beim Abscheiden der epitaktischen Schicht an der Randposition, die durch das Verschieben näher an die äußere Begrenzung der Ablagefläche des Suszeptors rückt, dem zugeordneten Dickenkennwert-Unterschied entsprechend weniger Material abgeschieden wird, als im gegenüberliegenden Randabschnitt. Dementsprechend ist der Dickenkennwert nach dem Abscheiden der epitaktischen Schicht im dünneren Randabschnitt der Substratscheibe um den Dickenkennwert-Unterschied größer, als er wäre, läge die Substratscheibe im Verlauf des Abscheidens der epitaktischen Schicht zentriert in der Tasche des Suszeptors und an der Randposition, die durch das Verschieben näher an die äußere Begrenzung der Ablagefläche des Suszeptors rückt, um den Dickenkennwert-Unterschied geringer. Der Verschiebevektor repräsentiert also eine Exzentrizität der Lage des Mittelpunkts der auf dem Suszeptor liegenden Substratscheibe im Vergleich zur Lage, die der Mittelpunkt hätte, läge die Substratscheibe zentriert in der Tasche des Suszeptors. Die Korrelations-Funktion wird vor der Beschichtung der Substratscheibe durch Versuche ermittelt, indem festgestellt wird, welche Exzentrizität welche Änderung des Dickenkennwerts zur Folge hat.

Wegen des besonderen Stellenwerts der Notchposition wird überprüft, ob der Dickenkennwert an der Notchposition der Substratscheibe um mehr als eine prozentuale Schranke vom Dickenkennwert an der Randposition mit dem größten Dickenkennwert abweicht. Die prozentuale Schranke wird vorgegeben und beträgt vorzugsweise 10 % des Dickenkennwerts an der Randposition mit dem größten Dickenkennwert.

Ist die Notchposition selbst diejenige Randposition mit dem größten Dickenkennwert, wird die Substratscheibe derart auf der Ablagefläche abgelegt, dass der Abstand, den die Substratscheibe zur äußeren Begrenzung der Ablagefläche hat, an der Notchposition kleiner ist, als an den anderen Randpositionen.

Weicht der Dickenkennwert an der Notchposition um mehr als die prozentuale Schranke vom Dickenkennwert an der Randposition mit dem größten Dickenkennwert ab, wird die Substratscheibe derart in der Tasche des Suszeptors abgelegt, dass der Abstand, den die Substratscheibe an der Randposition mit dem größten Dickenkennwert zur äußeren Begrenzung der Ablagefläche hat, kleiner ist, als an den anderen Randpositionen und kleiner, als wenn die Substratscheibe zentriert in der Tasche läge. Der Abstand ist um einen Verschiebevektor verkürzt, der mit einem Dickenkennwert-Unterschied verknüpft ist, weshalb eine vorgesehene reduzierte Materialabscheidung an der Randposition mit größtem Dickenkennwert während des Abscheidens der epitaktischen Schicht erfolgt.

Weicht der Dickenkennwert an der Notchposition um nicht mehr als die prozentuale Schranke vom Dickenkennwert an der Randposition mit dem größten Dickenkennwert ab, wird die Substratscheibe derart in der Tasche des Suszeptors abgelegt, dass der Abstand, den die Substratscheibe zur äußeren Begrenzung der Ablagefläche hat, an der Notchposition kleiner ist, als an den anderen Randpositionen, und kleiner ist, als wenn die Substratscheibe zentriert in der Tasche läge. Der Abstand ist um einen Verschiebevektor verkürzt, der mit einem Dickenkennwert-Unterschied verknüpft ist, weshalb eine vorgesehene reduzierte Materialabscheidung an der Notchposition während des Abscheidens der epitaktischen Schicht erfolgt.

Das Ablegen der Substratscheibe in die Tasche des Suszeptors erfolgt zweckmäßigerweise durch einen Roboter, der das nach Vorgabe der Korrelations-Funktion ausführt. Alternativ oder ergänzend kann der Roboter als selbstlernendes System konfiguriert sein, das mit den gemessenen Geometriedaten der Substratscheiben und der resultierenden epitaktisch beschichteten Halbleiterscheiben die nötige Exzentrizität für die Beschichtung nachfolgender Substratscheiben ermittelt und umsetzt. Darüber hinaus ist bevorzugt, die Ablage der Substratscheibe auf dem Suszeptor und deren Lage in der Tasche des Suszeptors mittels eines Kamerasystems zu überwachen.

Die äußere Begrenzung der Ablagefläche hat einen kreisförmigen oder nahezu kreisförmigen Umfang. Der Suszeptor weist vorzugsweise eine Ablagefläche auf, die an der Notchposition nach innen ragt, besonders bevorzugt in Kombination mit einer an der Notchposition nach innen ragender äußerer Begrenzung der Ablagefläche, beispielsweise in der Art, die in US 2017 0 117 228 A1 beschrieben ist. Liegt die Substratscheibe während des Abscheidens der epitaktischen Schicht an der Notchposition näher am Rand der äußeren Begrenzung der Abscheidefläche, behindert das Vorhandensein der nach innen ragenden Abscheidefläche eine Rückseitenbeschichtung an der Notchposition zusätzlich.

Die Substratscheibe und die darauf abgeschiedene epitaktische Schicht bestehen vorzugsweise im Wesentlichen aus Halbleitermaterial, beispielsweise aus einkristallinem Silizium. Die Substratscheibe hat vorzugsweise einen Durchmesser von mindestens 200 mm, besonders bevorzugt mindestens 300 mm. Die epitaktische Schicht hat vorzugsweise eine Dicke von 1 µm bis 20 µm.

Die Erfindung wird nachfolgend mit Verweis auf Zeichnungen näher beschrieben.

### Kurzbeschreibung der Figuren

**Fig. 1** zeigt qualitativ auf, wie die Erfindung wirkt.
**Fig. 2** zeigt eine in der Tasche des Suszeptors abgelegte Substratscheibe gemäß einer Ausgestaltung der Erfindung.
**Fig. 3** zeigt eine Korrelations-Funktion, die einer Exzentrizität E eine zu erwartende Änderung eines Dickenkennwerts zuordnet.
**Fig. 4** zeigt eine in der Tasche des Suszeptors abgelegte Substratscheibe gemäß einer weiteren Ausgestaltung der Erfindung.
**Fig. 5** zeigt die Wirkung der Ausgestaltung gemäß Fig.4 an einem Beispiel.

### Liste der verwendeten Bezugszeichen

- **1**: Substratscheibe
- **2**: epitaktische Schicht
- **3**: Suszeptor
- **4**: Ablagefläche
- **5**: dicker Randabschnitt der Substratscheibe
- **6**: dünner Randabschnitt der Substratscheibe
- **7**: äußere Begrenzung der Ablagefläche
- **8**: Karte
- **E**: Exzentrizität
- Δ**ESFQR**: Unterschied des ESFQR-Werts zum Zielwert

- **N**: Notchposition

### Detaillierte Beschreibung erfindungsgemäßer Ausführungsbeispiele

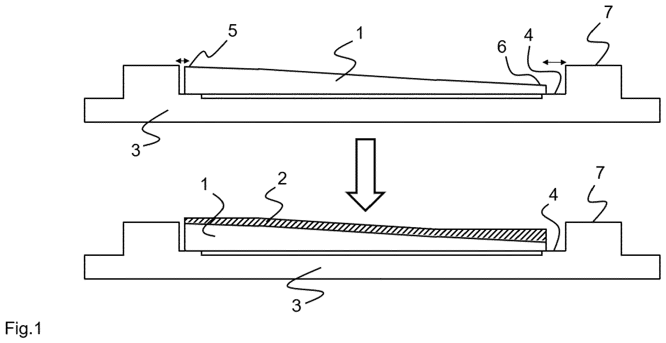

Fig.1 zeigt in Schnittdarstellung (Vertikalschnitt) eine in der Tasche eines Suszeptors 3 abgelegte Substratscheibe 1, die einen Randabschnitt 5 aufweist, der vergleichsweise dick ist, und einen gegenüberliegenden Randabschnitt 6, der vergleichsweise dünn ist. Die Substratscheibe 1 liegt nicht zentriert auf der Ablagefläche 4 der Tasche, sondern exzentrisch und zwar so, dass der dickere Randabschnitt 5 einen kleineren Abstand zu einer äußeren Begrenzung 7 der Ablagefläche 4 hat, als der dünnere Randabschnitt 6. Diese Konfiguration hat zur Folge, dass dort, wo der Abstand kleiner ist, die Geschwindigkeit des Aufwachsens von Material während des Abscheidens der epitaktischen Schicht geringer ist, als dort, wo der Abstand größer ist.

Der untere Teil von Fig.1 zeigt die Situation nach dem Abscheiden der epitaktischen Schicht 2. Aus der Substratscheibe 1 ist eine Substratscheibe mit abgeschiedener epitaktischer Schicht geworden, wobei die epitaktische Schicht 2 im Bereich des Randabschnitts mit kleinerem Abstand zur äußeren Begrenzung 7 dünner ist als im Bereich des Randabschnitts mit größerem Abstand zur äußeren Begrenzung 7. Wird die Dicke der Substratscheibe mit abgeschiedener epitaktischer Schicht 2 betrachtet und mit der Dicke der Substratscheibe 1 verglichen, stellt man fest, dass die Dicke der epitaktisch beschichteten Substratscheibe in deren Randbereich gleichmäßiger ist, als die Dicke der Substratscheibe 1. Die Dickenunterschiede im Randbereich sind im Fall der Substratscheibe 1 ausgeprägter, als im Fall der epitaktisch beschichteten Substratscheibe.

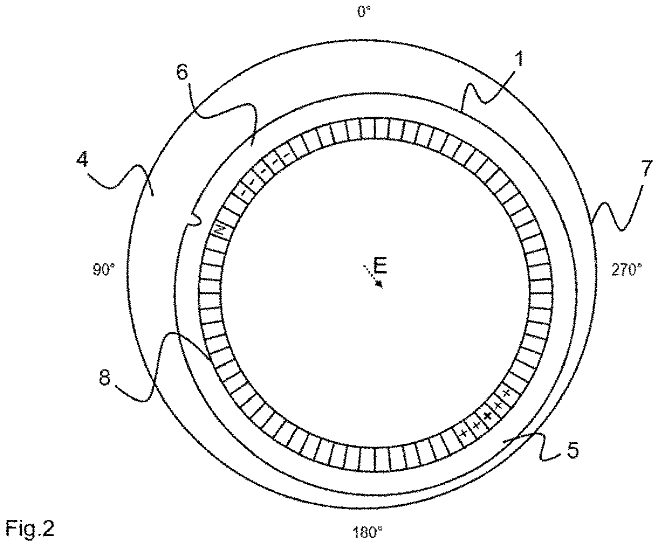

Fig. 2 zeigt in Draufsicht eine erfindungsgemäß in der Tasche des Suszeptors abgelegte Substratscheibe. Die Substratscheibe 1 liegt nicht zentrisch in der Tasche des Suszeptors. Der Mittelpunkt der Substratscheibe ist entsprechend der Exzentrizität E vom Mittelpunkt der Tasche verschoben und zwar so, dass die Randposition mit dem größten Dickenkennwert den kleinsten Abstand zur äußeren Begrenzung 7 der Ablagefläche 4 hat. Richtung und Betrag der Exzentrizität E sind abhängig von einer Messung der Randgeometrie der Substratscheibe, beispielsweise indem in 5° breiten Randsegmenten die Ebenheit in Form des ESFQR-Werts gemessen wird. Das Ergebnis der Messung ist durch die eingezeichnete Karte 8 qualitativ angedeutet und weist den mit "+" - Symbolen hervorgehobenen dickeren Randabschnitt 5 und den mit "-" - Symbolen hervorgehobenen dünneren Randabschnitt 6 aus. Die Randposition mit dem größten Dickenkennwert ist fett gedruckt markiert. Die Länge der Exzentrizität E ist nicht maßstabsgetreu gezeichnet. Erfindungsgemäß zeigt die Exzentrizität E zur Randposition mit dem größten Dickenkennwert, sofern der Dickenkennwert an der Notchposition vom Dickenkennwert an der Randposition mit dem größten Dickenkennwert derart abweicht, dass die Abweichung größer als eine prozentuale Schranke ist.

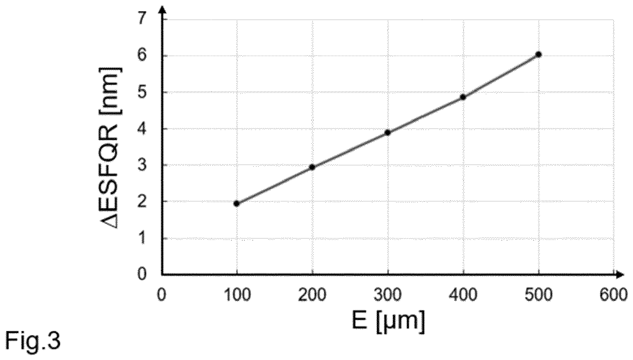

Die gewählte Exzentrizität E basiert auf einer Korrelations-Funktion, die durch Vorversuche für die zur Anwendung kommende Abscheidevorrichtung bestimmt wird. Dabei wird untersucht, welche Änderung des Dickenkennwerts zu erwarten ist, wenn die Substratscheibe mit einer bestimmten Exzentrizität E in der Tasche des Suszeptors abgelegt wird. Im ausgewählten Beispiel zeigt die Korrelations-Funktion gemäß Fig. 3 an, welcher Unterschied ΔESFQR des ESFQR-Werts im dünneren Randabschnitt nach der Abscheidung erhalten wird, wenn die Substratscheibe vor der Abscheidung nicht zentrisch, sondern mit der entsprechenden Exzentrizität E in die Tasche des Suszeptors abgelegt wird. Die Korrelations-Funktion gemäß Fig. 3 lässt also erwarten, dass nach dem Abscheiden der epitaktischen Schicht der ESFQR-Wert in den Sektoren des dünneren Randabschnitts um etwa 2 nm größer sein wird, sofern die Substratscheibe vor dem Abscheiden nicht zentrisch, sondern mit einer Exzentrizität von 100 µm in der Tasche des Suszeptors abgelegt wurde. Im dickeren Randabschnitt ist ein entsprechend kleinerer ESFQR-Wert zu erwarten.

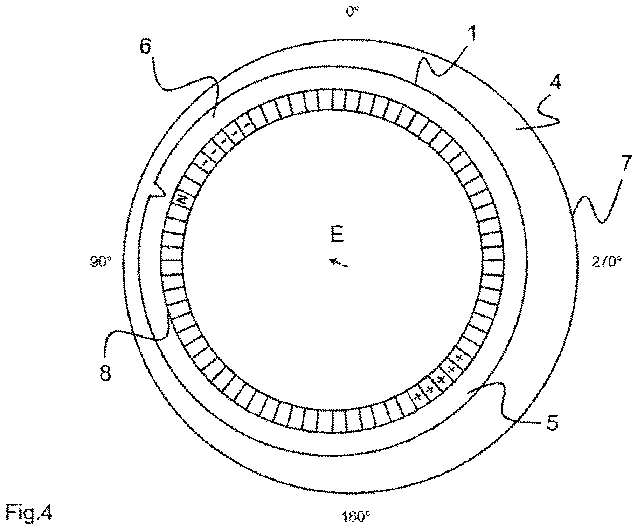

Fig. 4 zeigt die Situation, wenn der Dickenkennwert an der Notchposition vom Dickenkennwert an der Randposition mit dem größten Dickenkennwert derart abweicht, dass die Abweichung nicht größer als die prozentuale Schranke ist. In diesem Fall zeigt die Exzentrizität E nicht zur Randposition mit dem größten Dickenkennwert, sondern zur Notchposition N.

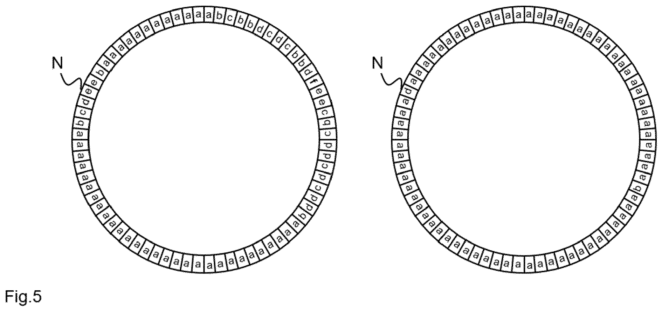

Fig. 5 zeigt die Wirkung der Ausgestaltung gemäß Fig.4 an einem Beispiel. Dargestellt ist das Ergebnis der Messung der Dickenkennwerte einer Substratscheibe aus einkristallinem Silizium mit einem Durchmesser von 300 mm vor dem Abscheiden einer epitaktischen Schicht aus einkristallinem Silizium (linke Abbildung) und der epitaktisch beschichteten Substratscheibe (rechte Abbildung). Die Randgeometrie ist in Kategorien von ESFQR-Werten codiert, von Kategorie a bis Kategorie f, wobei die Randposition mit Kategorie f die Randposition mit dem größten Dickenkennwert bezeichnet. Die Überprüfung der Messergebnisse offenbart, dass der Dickenkennwert an der Notchposition mit Kategorie e vergleichsweise geringfügig vom Dickenkennwert der Randposition mit dem größten Dickenkennwert, nämlich der Kategorie f, abweicht. Die Abweichung war geringer, als die vorgegebene Schranke, und dementsprechend wurde die Substratscheibe zum Abscheiden der epitaktischen Schicht derart auf die Ablagefläche des Suszeptors gelegt, dass der Abstand, den die Substratscheibe zur äußeren Begrenzung der Ablagefläche hatte, an der Notchposition kleiner war, als an den anderen Randpositionen. Wie die linke Abbildung zeigt, verbesserte sich der Dickenkennwert an der Notchposition zu Kategorie d ohne zu Lasten der anderen Randpositionen.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen durch den Schutzbereich der Ansprüche abgedeckt sein.

## Patentansprüche

1. Verfahren zum Abscheiden einer epitaktischen Schicht auf einer Substratscheibe aus einer Gasphase, umfassend
das Messen einer Randgeometrie der Substratscheibe, das einem Rand der Substratscheibe in Abhängigkeit von Randpositionen einen Dickenkennwert zuweist, auch den Dickenkennwert an einer Notchposition;
das Ablegen der Substratscheibe auf einer Ablagefläche einer Tasche eines Suszeptors einer Vorrichtung zum Abscheiden der epitaktischen Schicht, wobei die Ablagefläche von einer äußeren Begrenzung umgeben ist;
das Erhitzen der Substratscheibe; und
das Leiten von Prozessgas über die Substratscheibe;
**gekennzeichnet durch**
das Überprüfen ob der Dickenkennwert an der Notchposition um mehr als eine prozentuale Schranke vom Dickenkennwert an einer Randposition mit dem größten Dickenkennwert abweicht;
das Ablegen der Substratscheibe auf der Ablagefläche derart, dass der Abstand, den die Substratscheibe zur äußeren Begrenzung der Ablagefläche hat, an der Randposition mit dem größten Dickenkennwert kleiner ist, als an den anderen Randpositionen, sofern die Abweichung größer als die prozentuale Schranke ist, oder derart, dass der Abstand, den die Substratscheibe zur äußeren Begrenzung der Ablagefläche hat, an der Notchposition kleiner ist, als an den anderen Randpositionen, sofern die Abweichung nicht größer als die prozentuale Schranke ist.

2. Verfahren nach Anspruch 1, **gekennzeichnet durch** das Messen des ESFQR oder des ZDD als Dickenkennwert.

3. Verfahren nach Anspruch 1 oder Anspruch 2, **gekennzeichnet durch** das Ablegen der Substratscheibe mittels eines Roboters.

4. Verfahren nach einem der Ansprüche 1 bis 3, **gekennzeichnet durch** das Überwachen der Lage der Substratscheibe in der Tasche mittels eines Kamerasystems.

5. Verfahren nach einem der Ansprüche 1 bis 4, **gekennzeichnet durch** das Abscheiden einer epitaktischen Schicht aus Silizium auf einer Substratscheibe aus einkristallinem Silizium.

## Claims

1. Method for depositing an epitaxial layer on a substrate wafer from a gas phase, comprising
measuring an edge geometry of the substrate wafer, which assigns a characteristic thickness value to an edge of the substrate wafer as a function of edge positions, including the characteristic thickness value at a notch position;
placing the substrate wafer on a placement area of a pocket of a susceptor of an apparatus for depositing the epitaxial layer, the placement area being surrounded by an outer boundary;
heating the substrate wafer; and
passing process gas over the substrate wafer;
**characterized by**
verifying whether the characteristic thickness value at the notch position differs by more than a percentage limit from the characteristic thickness value at an edge position having the greatest characteristic thickness value;
placing the substrate wafer on the placement area in such a way that the distance of the substrate wafer from the outer boundary of the placement area is smaller at the edge position having the greatest characteristic thickness value than at the other edge positions, provided that the difference is greater than the percentage limit, or in such a way that the distance of the substrate wafer from the outer boundary of the placement area is smaller at the notch position than at the other edge positions, provided that the difference is not greater than the percentage limit.

2. Method according to Claim 1, **characterized by** the measuring of the ESFQR or the ZDD as characteristic thickness value.

3. Method according to Claim 1 or Claim 2, **characterized by** the placing of the substrate wafer via a robot.

4. Method according to any of Claims 1 to 3, **characterized by** the monitoring of the position of the substrate wafer in the pocket via a camera system.

5. Method according to any of Claims 1 to 4, **characterized by** the depositing of an epitaxial layer of silicon on a substrate wafer made of monocrystalline silicon.

## Revendications

1. Procédé de dépôt d'une couche épitaxiale sur une tranche de substrat à partir d'une phase gazeuse, comprenant
mesure d'une géométrie de bord de la tranche de substrat, qui attribue une valeur d'épaisseur caractéristique à un bord de la tranche de substrat en fonction des positions de bord, y compris la valeur d'épaisseur caractéristique à une position d'encoche ;
placer la tranche de substrat sur une zone de placement d'une poche d'un suscepteur d'un appareil pour déposer la couche épitaxiale, la zone de placement étant entourée de
une limite extérieure ;
chauffer la plaquette de substrat ; et
le passage d'un gaz de traitement sur la tranche de
substrat ; **caractérisé par**
vérifier si la valeur de l'épaisseur caractéristique à la position de l'encoche diffère de plus d'une limite de pourcentage de la valeur de l'épaisseur caractéristique à une position du bord ayant la plus grande valeur d'épaisseur caractéristique ;
placer la plaquette de substrat sur la zone de placement de manière à ce que la distance de la plaquette de substrat par rapport à la limite extérieure de la zone de placement soit plus petite à la position du bord ayant la plus grande valeur d'épaisseur caractéristique qu'à l'autre bord.
positions, à condition que la différence soit supérieure à la limite du pourcentage, ou de telle manière que la distance de la tranche de substrat par rapport à la limite extérieure de la zone de placement soit plus petite à la position de l'encoche qu'aux autres positions du bord, à condition que la différence ne soit pas supérieure à la limite du pourcentage.

2. Procédé selon la revendication 1, **caractérisé par** la mesure de l'ESFQR ou de la ZDD comme valeur d'épaisseur caractéristique.

3. Procédé selon la revendication 1 ou la revendication 2, **caractérisé par** la mise en place de la tranche de substrat par un robot.

4. Procédé selon l'une quelconque des revendications 1 à 3, **caractérisé par** la surveillance de la position de la plaquette de substrat dans la poche par un système de caméra.

5. Méthode selon l'une quelconque des revendications 1 à 4, **caractérisée par** le dépôt d'un couche épitaxiale de silicium sur une tranche de substrat en silicium monocristallin.
